# EUROPÄISCHE PATENTANMELDUNG

(11) **EP 1 655 775 A1**
(43) Veröffentlichungstag der Anmeldung: **10.05.2006**
(21) Anmeldenummer: 05023817.9
(22) Anmeldetag: 02.11.2005
(51) Int. Cl.: H01L 21/762, H01L 21/20

(54) **Halbleiteranordnung und Verfahren zur Herstellung einer Halbleiteranordnung**

(30) Priorität: 03.11.2004 DE 102004053016
(71) Anmelder: ATMEL Germany GmbH, 74072 Heilbronn (DE)
(72) Erfinder: Bromberger, Christoph, Dipl.-Phys., 74074 Heilbronn (DE)

(57) **Zusammenfassung**

Verfahren zur Herstellung einer Halbleiteranordnung, indem
- in ein erstes, monokristallines Hatbteitergebiet (1) eine Grabenstruktur eingebracht wird,
- die Grabenstruktur mit einem Isolator (3) verfüllt wird, wobei eine Anzahl von Schichten des Isolators (3) zusammen einen Wärmeleitwert größer 20 W/mK aufweisen,
- auf dem Isolator (3) und auf einer freiliegenden Oberfläche des ersten Halbleitergebietes (1) eine amorphe Siliziumschicht abgeschieden wird, die ausgehend von der als Saatfenster wirkenden, freiliegenden Oberfläche des ersten Halbleitergebietes (1) lateral über dem Isolator (3) auskristallisiert wird, so dass auf dem Isolator (3) ein zweites, zumindest teilweise monokristallines Halbleitergebiet (2) gebildet wird.

## Beschreibung

Die vorliegende Erfindung betrifft eine Halbleiteranordnung und ein Verfahren zur Herstellung einer Halbleiteranordnung.

Insbesondere zur Verringerung der Übersprechneigung, zum Zwecke höherer Isolation und bei höher leitfähigen Substraten zur Verringerung der Substratkapazität, werden integrierte mikroelektronische Bauelemente durch eine dielektrische Schicht von einem (halb)leitenden Trägerwafer isoliert.

Hierzu kann ein SOI-Wafermaterial (Silicon on Insulator) verwendet werden, bei dem ein unterer Handlingwafer durch eine durchgehende Siliziumdioxidschicht von einem aufliegenden Device-Wafer abgetrennt wird. Dies ist beispielsweise in der US 6,552,395 B1, der DD 250 403 A1 und der US 5,855,693 offenbart.

Alternativ können lateral begrenzt Gräben in einem Handlingwafer aus monokristallinem Silizium mit Siliziumdioxid verfüllt werden. Außerhalb der siliziumdioxid-gefüllten Gräben tritt dabei monokristallines Silizium an eine Oberfläche. In einem darauf folgenden Prozessschritt wird eine Schicht aus amorphem Silizium aufgebracht, und dieses durch geeignete Temperaturbeaufschlagung, ausgehend von den offen liegenden monokristallinen Siliziumbereichen als seed-layer, zu Kristallisation gebracht (LEO: "lateral epitaxial overgrowth).

In Journal of the Electrochemical Society, 138 (1991), Nr. 12, p. 3771-3777; Journal of Crystal Growth 98 (1989), p. 519-530; Applied Physics Letters, 49 (7), 1996, p. 397-399; Applied Physics Letters, 60 (1), 1992, p. 80-81; Applied Physics Letters, 52 (20), 1988, p. 1681-1683; Applied Physics Letters, 43 (11), 1983, p. 1028-1030; Applied Physics Letters, 52 (21), 1988, p. 1788-1790; Applied Physics Letters, 65 (6), 1990, p. 560-562; Applied Physics Letters, 48 (12), 1986, p. 773-775; Applied Physics Letters, 53 (26), 1988, p. 2626-2628; Applied Physics Letters, 49 (20), 1986, p. 1363-1365; Journal of Applied Physics, 64 (6), 1988, p. 3018-3023; Japanese Journal of Applied Physics, 35, 1996, p-1605-1610; und Japanese Journal of Applied Physics, 31, 1992, p-1695-1701 sind verschiedene Herstellungsvarianten für Halbleiterbauelemente durch teilweises Überwachsen von Siliziumdioxidschichten mit monokristallinem Silizium per Festphasenepitaxie beschrieben. Hierzu wird auf einen Siliziumwafer zunächst eine Siliziumdioxidschicht aufgebracht. In der Siliziumdioxidschicht werden Saatfenster geöffnet, an denen das monokristalline Gitter des Wafers freiliegt. Anschließend wird eine amorphe Siliziumschicht aufgebracht, und diese, ausgehend von den Saatöffnungen, kristallisiert.

Diese Schriften zeigen, dass seit Beginn dieser Technologie Anfang der 80er Jahre des 2. Jahrtausends sehr dünne Schichten mit Siliziumdioxid als Isolator aufgebracht wurden. Seit fast 30 Jahren bis zur Gegenwart wird dieses Verfahren des Überwachsens von Siliziumdioxid optimiert, wie dies neueren Datums in der US 6,066,872 offenbart ist.

Aufgabe der vorliegenden Erfindung ist es, eine Halbleiteranortfnung anzugeben, die eine möglichst hohe Integrationsdichte und Leistungsdichte von integrierten Leistungsbauelementen auf einem Isolator ermöglicht.

Diese Aufgabe wird durch eine Halbleiteranordnung mit den Merkmalen des Anspruches 2 und durch ein Verfahren zur Herstellung einer Halbleiteranordnung mit den Merkmalen des Anspruchs 1 gelöst. Vorteilhafte Weiterbildungen der Erfindung sind Gegenstand von Unteransprüchen.

Demzufolge ist eine Halbleiteranordnung mit einem ersten, monokristallinen Halbleitergebiet, einem elektrischen Isolator und einem zweiten, zumindest teilweise monokristallinen Halbleitergebiet vorgesehen. In dem zweiten, zumindest teilweise monokristallinen Halbleitergebiet ist zumindest ein aktives Bauelement integriert, das im Betrieb eine Wärmequelle bildet.

Dadurch, dass der dielektrische Isolator auf das erste, monokristalline Halbleitergebiet aufgebracht ist, ist das zumindest eine aktive, integrierte Bauelement von dem ersten Halbleitergebiet elektrisch isoliert. In das erste Halbleitergebiet sind vorteilhafterweise weitere Bauelemente integriert, die von dem zumindest einem aktiven, integrierten Bauelement des zweiten Halbleitergebiets isoliert werden müssen.

Das zweite, zumindest teilweise monokristalline Halbleitergebiet ist aus einem amorphen Halbleitermaterial, ausgehend von einer freigelegten Oberfläche des ersten, monokristallinen Halbleitergebietes als Saatfenster zumindest teilweise kristallisiert, Für die Isolation bedeckt das zweite monokristalline Halbleitergebiet teilweise den elektrischen Isolator.

Das Wesen der Erfindung besteht darin, dass der elektrische Isolator eine Schicht aus intrinsischem Siliziumcarbid (SiC) und/oder eine Schicht aus Siliziumnitrid (Si₃N₄) und/oder eine Schicht aus Aluminiumnitrid (AIN) und/oder eine Schicht aus Berylliumoxid (BeO) aufweist. Der Isolator besteht aus einer Anzahl von Schichten, wobei die Anzahl größer oder gleich eins ist. Der Isolator weist einen Gesamt-Wärmeleitwert größer 20 W/mK aufweist, der aus der Anzahl der Schichten insgesamt gebildet wird.

Dieser Gesamt-Wärmeleitwert liegt mit 20W/mK damit deutlich über dem Wärmeleitwert von Siliziumdioxid von 1,4 W/mK, so dass insbesondere innerhalb von Hochfrequenzschaltungen Bauelemente mit einer höheren, als im Stand der Technik erzielbaren Leistungsdichte verwendet werden können, während dennoch deren Verlusiwärme über den elektrischen Isolator in das verwendete Substrat abführbar ist. Eine derartige insbesondere linienförmige Wärmequelle ist beispielsweise ein lang gestreckter Bipolartransistor in dem zweiten monokristallinen Halbleitergebiet.

Für eine weitergehende dielektrische Isolation des zweiten, monokristallinen Halbleitergebietes von dem ersten, monokristallinen Halbleitergebiet ist in einer vorteilhaften Ausgestaltung der Erfindung vorgesehen, dass im Bereich des Saatfensters das Halbleitermaterial durch Ätzung und/oder Oxidation entfernt ist.

Vorteilhafte Weiterbildungen der Erfindung sehen vor, dass der Isolator einen Schichtstapel aus vorzugsweise mehreren Schichten aufweist. In einer ersten Weiterbildungsvariante weist der dielektrische Isolator eine Schicht aus intrinsischem Siliziumcarbid (SiC) auf. Eine zweite Weiterbildungsvariante sieht hingegen vor, dass der elektrische Isolator eine Schicht aus Siliziumnitrid (Si₃N₄) aufweist.

Insbesondere für Hochfrequenzanwendungen weist vorteilhafterweise der elektrische Isolator einen Wärmeleitwert größer 100 W/mK auf. Wird hingegen sogar ein Isolator mit einem Wärmeleitwert größer oder gleich 150 W/mK verwendet, kann eine Wärmeableitung vergleichbar mit einem Siliziumsubstrat erzielt werden.

Eine andere Weiterbildung der Erfindung sieht vor, dass das zweite monokristalline Halbleitergebiet eine Siliziumschicht (Si) und/oder eine Silizium-Germanium-Schicht (SiGe) mit aktiven Gebieten eines integrierten Bauelementes aufweist.

Als ein Dielektrikum im Isolator können in Weiterbildungsvarianten der Erfindung unterschiedliche Materialen einzeln oder in Kombination verwendet werden. In einer vorteilhaften Weiterbildungsvariante der Erfindung weist der elektrische Isolator eine Schicht aus Aluminiumnitrid (AIN) auf.

Gemäß einer anderen bevorzugten Weiterbildungsvariante weist der elektrische Isolator eine Schicht aus Berylliumoxid (BeO) auf. Zwei Ausgestaltungsvarianten ermöglichen das Erzeugen einer Berylliumoxidschicht.

In einer vorteilhaften ersten Ausgestaltungsvariante ist die Schicht aus Berylliumoxid (BeO) durch Elektronenstrahlverdampfen oder Sputtem eines Berylliumoxidtargets aufgebracht. Alternativ ist in einer bevorzugten zweiten Ausgestaltungsvariante die Schicht aus Berylliumoxid (BeO) durch Oxidation einer Berylliumschicht (Be) erzeugt.

In einer besonders bevorzugten Weiterbildung der Erfindung ist eine Diffusionsbarriereschicht zwischen dem ersten Halbleitergebiet und der Schicht aus Berylliumoxid (BeO) und/oder der Schicht aus Aluminiumnitrid (AIN) angeordnet. Die Diffusionsbarriere verhindert eine Diffusion von Beryllium oder Aluminium in das erste Halbleitergebiet, das beispielsweise aus Silizium besteht.

In einer anderen, besonders bevorzugten Weiterbildung der Erfindung ist eine (weitere) Diffusionsbarriereschicht zwischen dem zweiten Halbleitergebiet und der Schicht aus Berylliumoxid (BeO) und/oder der Schicht aus Aluminiumnitrid (AIN) angeordnet. Diese Diffusionsbarriereschicht verhindert eine Diffusion von Beryllium oder Aluminium in das zweite Halbleitergebiet, das beispielsweise Silizium oder ein monokristallines Mischkristall aufweist.

Die Erfindung bevorzugt weiterbildend, weist die Diffusionsbarriereschicht eine an das erste Halbleitergebiet und/oder zweite Halbleitergebiet angrenzende Siliziumdioxidschicht und eine an die Schicht aus Berylliumoxid (BeO) und/oder der Schicht aus Aluminiumnitrid (AIN) angrenzende Siliziumnitridschicht auf. Dabei verhindert die Siliziumnitridschicht, dass Beryllium mit dem Siliziumdioxid bei hohen Temperaturen zu einer schwer löslichen Verbindung reagiert.

Eine andere vorteilhafte Weiterbildung sieht als Diffusionsbarriere eine Schicht aus Titannitrid (TiN) vor. Ebenfalls ist es möglich eine Titannitridschicht mit anderen Schichten für eine Diffusionsbarriere zu kombinieren.

Um eine günstige Geometrie und insbesondere eine im Wesentlichen plane Oberfläche zu erhalten, ist in einer vorteilhaften Weiterbildung vorgesehen, dass eine oder mehrere Schichten des elektrischen Isolators eine in dem ersten monokristallinen Halbleitergebiet strukturierte Grabenstruktur verfüllen.

Ein weiterer Aspekt der Erfindung ist eine Verwendung einer zuvor erläuterten Halbleiteranordnung in einem integrierten Hochleistungsschaltkreis oder in einem integrierten Hochfrequenzschaltkreis.

Ein anderer Aspekt ist das Herstellungsverfahren zur Herstellung einer Halbleiteranordnung, wobei das Wesen der Erfindung in der Erzeugung eines Isolators mit einem Wärmeleitwert größer 20 W/mK liegt. Demzufolge kann auch ein durchgehender Isolator die aktiven Bauelemente von einem Handling-Wafer elektrisch isolieren. Bevorzugt ist jedoch vorgesehen, dass in dem Verfahren zur Herstellung einer Halbleiteranordnung in ein erstes, monokristallines Halbleitergebiet eine Grabenstruktur eingebracht und die Grabenstruktur mit einem elektrischen Isolator verfüllt wird. Dabei bewirken mehrere Schichten des elektrischen Isolators zusammen einen Wärmeleitwert größer 20 W/mK.

Nachfolgend wird auf dem elektrischen Isolator und auf einer freiliegenden Oberfläche des ersten Halbleitergebietes eine amorphe Siliziumschicht abgeschieden, die ausgehend von der als Saatfenster wirkenden, freiliegenden Oberfläche des ersten Halbleitergebietes lateral über dem Isolator auskristallisiert wird, so dass auf dem Isolator ein zweites, zumindest teilweise monokristallines Halbleitergebiet gebildet wird.

Im Folgenden wird die Erfindung in einem Ausführungsbeispiel anhand einer zeichnerischen Darstellung näher erläutert.

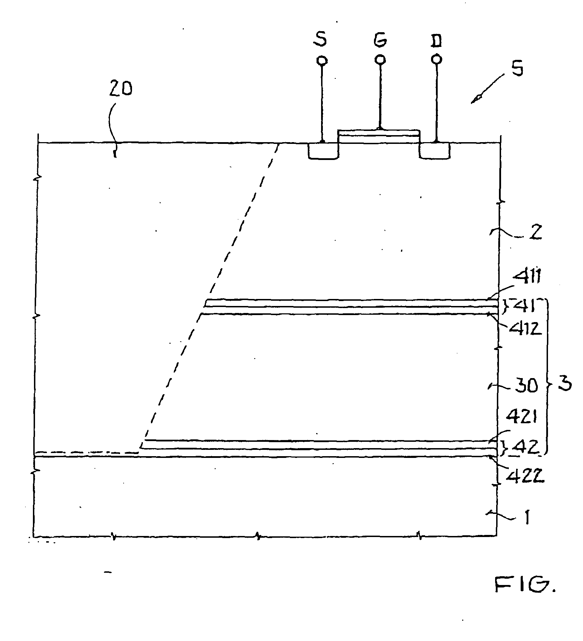

In der Figur ist eine schematische Schnittdarstellung durch eine Halbleiteranordnung dargestellt. In diesem Ausführungsbeispiel ist das erste, monokristalline Halbleitergebiet 1 einkristallines Silizium mit der Orientierung <100>. Auf diesem ersten, monokristallinen Halbleitergebiet 1 ist ein Isolator 3 aufgebracht, der ein zweites, monokristallines Halbleitergebiet 2 von dem ersten, monokristallinen Halbleitergebiet 1 elektrisch isoliert. Das zweite, monokristalline Halbleitergebiet 2 weist eine oder mehrere Silizium- und Silizium-Germanium-Schichten auf, die in der Figur jedoch nicht dargestellt sind. Durch den Isolator soll beispielsweise eine parasitäre Kapazität zwischen dem Bauelement 5, hier schematisch dargestellt als Feldeffekttransistor, und dem ersten Halbleitergebiet 1 signifikant reduziert werden.

Der Isolator 3 besteht aus mehreren Schichten 42 (422, 421), 30, und 41 (412, 411). Die Schicht 30 ist dabei ein Dielektrikum, dass den Gesamtwärmeleitwert des Isolators 3 aufgrund der Dicke dieser Schicht 30 dominiert. Das Dielektrikum 30 weist in diesem Ausführungsbeispiel Berylliumoxid (BeO) auf. Alternativ oder in Kombination weist das Dielektrikum 30 Aluminiumnitrid (AIN) auf.

Der Isolator 3 grenzt mit einer ersten Grenzfläche an das erste Halbleitergebiet 1 und mit einer zweiten Grenzfläche an das zweite Halbleitergebiet 2. Um eine Diffusion von Beryllium (Be) in das erste Halbleitergebiet 1 zu verhindern, ist eine erste Diffusionsbarriere 42 vorgesehen, die eine, an das erste Halbleitergebiet 1 angrenzende Siliziumdioxidschicht 422 und eine, an das Dielektrikum 30 angrenzende Siliziumnitridschicht 421 aufweist. Die Siliziumnitridschicht bewirkt dabei, dass das Beryllium (Be) vom Siliziumdioxid (SiO₂) getrennt ist, da Be mit SiO₂ bei hohen Temperaturen zu schwer löslichen Verbindungen reagiert.

Ein analoger Aufbau gilt für die zweite Diffusionsbarriere 41, die zwischen dem Dielektrikum 30 und dem zweiten Halbleitergebiet 2 angeordnet ist. Diese weist eine, an das Dielektrikum 30 angrenzende Siliziumnitridschicht 412 und eine, an das zweite Halbleitergebiet 2 angrenzende Siliziumdioxidschicht 411 auf. Jede Diffusionsbarriere 41, 42 weist eine gegenüber dem Dielektrikum 30 wesentlich kleinere Schichtdicke auf.

Das zweite Halbleitergebiet 2 ist ausgehen von einem, in der Figur nicht dargestellten Saatfenster im Isolator 3 aus einem oder mehreren amorph abgeschiedenen Materialien kristallisiert. Der Bereich des Saatfensters ist durch die Ätzung einer Grabenstruktur 20 entfernt worden, so dass der zweite Halbleiterbereich 2 von dem ersten Halbleiterbereich 1 durch diese Grabenstruktur 20 beabstandet und durch den Isolator 3 elektrisch isoliert ist. Innerhalb dieser Grabenstruktur kann ein weiteres, in der Figur nicht dargestelltes Bauelement ausgebildet werden.

Weiterhin können aktive Gebiete innerhalb der ersten Halbleitergebietes 1 durch Implantation erzeugt werden oder die Grabenstruktur 20 kann durch ein Dielektrikum verfüllt werden. Auch diese alternativen oder kombinierbaren weiteren Prozessschritte sind in der Figur nicht dargestellt.

## Patentansprüche

1. Verfahren zur Herstellung einer Halbleiteranordnung, indem
- in ein erstes, monokristallines Halbleitergebiet (1) eine Grabenstruktur eingebracht wird,
- die Grabenstruktur mit einem Isolator (3) verfüllt wird, wobei eine Anzahl von Schichten des Isolators (3) zusammen einen Wärmeleitwert größer 20 W/mK aufweisen,
- auf dem Isolator (3) und auf einer freiliegenden Oberfläche des ersten Halbleitergebietes (1) eine amorphe Siliziumschicht abgeschieden wird, die ausgehend von der als Saatfenster wirkenden, freiliegenden Oberfläche des ersten Halbleitergebietes (1) lateral über dem Isolator (3) auskristallisiert wird, so dass auf dem Isolator (3) ein zweites, zumindest teilweise monokristallines Halbleitergebiet (2) gebildet wird.

2. Halbleiteranordnung mit
- einem ersten, monokristallinen Halbleitergebiet (1),
- einem Isolator (3), der auf das erste, monokristalline Halbleitergebiet (1) aufgebracht ist,
- einem zweiten, zumindest teilweise monokristallinen Halbleitergebiet (2), das aus einem amorphen Halbleitermaterial, ausgehend von einer freigelegten Oberfläche des ersten, monokristallinen Halbleitergebietes (1) als Saatfenster zumindest teilweise kristallisiert ist,
wobei
- das zweite, zumindest teilweise monokristalline Halbleitergebiet (2) teilweise den Isolator (3) bedeckt, und
- der Isolator (3) eine Schicht aus intrinsischem Siliziumcarbid (SiC) und/oder eine Schicht aus Siliziumnitrid (Si₃N₄) und/oder eine Schicht aus Aluminiumnitrid (AIN) und/oder eine Schicht aus Berylliumoxid (BeO) aufweist und dieser Isolator (3) einen Gesamt-Wärmeleitwert größer 20 W/mK aufweist.

3. Halbleiteranordnung nach Anspruch 2,
**dadurch gekennzeichnet, dass**
der Isolator (3) einen Gesamt-Wärmeleitwert größer 100 W/mK, vorzugsweise größer 150 W/mK aufweist.

4. Halbleiteranordnung nach einem der vorhergehenden Ansprüche,
**dadurch gekennzeichnet, dass**
das zweite, zumindest teilweise monokristalline Halbleitergebiet (2) eine Siliziumschicht und/oder eine Silizium-Germanium-Schicht (SiGe) mit aktiven Gebieten eines integrierten Bauelementes (5) aufweist.

5. Halbleiteranordnung nach einem der vorhergehenden Ansprüche,
**dadurch gekennzeichnet, dass**
die Schicht aus Berylliumoxid (BeO) durch Elektronenstrahlverdampfen oder Sputtem eines Berylliumoxidtargets aufgebracht ist.

6. Halbleiteranordnung nach einem der Ansprüche 1 bis 4,
**dadurch gekennzeichnet, dass**
die Schicht aus Berylliumoxid (BeO) durch Oxidation einer Berylliumschicht (Be) erzeugt ist.

7. Halbleiteranordnung nach einem der vorhergehenden Ansprüche,
**dadurch gekennzeichnet, dass**
eine Diffusionsbarriereschicht (42) des Isolators (3) zwischen dem ersten monokristallinen Halbleitergebiet (1) und der Schicht aus Berylliumoxid (BeO) und/oder der Schicht aus Aluminiumnitrid (AIN) angeordnet ist.

8. Halbleiteranordnung nach einem der vorhergehenden Ansprüche,
**dadurch gekennzeichnet, dass**
eine Diffusionsbarriereschicht (41) des Isolators (3) zwischen dem zweiten, zumindest teilweise monokristallinen Halbleitergebiet (2) und der Schicht aus Berylliumoxid (BeO) und/oder der Schicht aus Aluminiumnitrid (AIN) angeordnet ist.

9. Halbleiteranordnung nach einem der Ansprüche 7 oder 8,
**dadurch gekennzeichnet, dass**
die Diffusionsbarriereschicht (41, 42) des Isolators (3) eine an das erste monokristalline Halbleitergebiet (1) und/oder zweite, zumindest teilweise monokristalline Halbleitergebiet (2) angrenzende Siliziumdioxidschicht (411, 422) und eine an die Schicht aus Berylliumoxid (BeO) und/oder der Schicht aus Aluminiumnitrid (AIN) angrenzende Siliziumnitridschicht (412, 421) aufweist.

10. Halbleiteranordnung nach einem der Ansprüche 7 bis 9,
**dadurch gekennzeichnet, dass**
die Diffusionsbarriereschicht (41, 42) des isolators (3) eine Titannitridschicht (TiN) aufweist.

11. Halbleiteranordnung nach einem der vorhergehenden Ansprüche,
**dadurch gekennzeichnet, dass**
eine oder mehrere Schichten des Isolators (3) eine in dem ersten monokristallinen Halbleitergebiet (1) strukturierte Grabenstruktur verfüllen.

12. Verwendung einer Halbleiteranordnung nach einem der Ansprüche 2 bis 11 in einem integrierten Hochleistungsschaltkreis.

13. Verwendung einer Halbleiteranordnung nach einem der Ansprüche 2 bis 11 in einem integrierten Hochfrequenzschaltkreis.
